# EUROPÄISCHE PATENTSCHRIFT

(11) **EP 1 807 708 B1**
(45) Veröffentlichungstag und Bekanntmachung des Hinweises auf die Patenterteilung: **05.08.2009**
(21) Anmeldenummer: 05800153.8
(22) Anmeldetag: 02.11.2005
(51) Int. Cl.: G01R 19/00, G01R 1/20, H01R 12/32

(54) **BATTERIESTROMSENSOR FÜR EIN KRAFTFAHRZEUG**
BATTERY CURRENT SENSOR FOR A MOTOR VEHICLE
CAPTEUR DE COURANT DE BATTERIE POUR VÉHICULE AUTOMOBILE

(30) Priorität: 03.11.2004 DE 102004053648
(43) Veröffentlichungstag der Anmeldung: 18.07.2007
(73) Patentinhaber: Leopold Kostal GmbH & Co. KG, 58507 Lüdenscheid (DE)
(72) Erfinder: DREISKEMPER, Heinrich-Wilhelm, 45966 Gladbeck (DE); LENHARD, Holger, 58454 Witten (DE)
(86) Internationale Anmeldenummer: PCT/EP2005/011678
(87) Internationale Veröffentlichungsnummer: WO 2006/048232

(56) Entgegenhaltungen:
- EP-A- 0 731 526
- DE-U- 20 318 266
- US-A- 4 513 499
- US-B1- 6 304 062

## Beschreibung

Die vorliegende Erfindung betrifft einen Batteriestromsensor für ein Kraftfahrzeug, mit einem in den Batteriestromkreis eingefügten Meßsensor und mit einer mit dem Meßsensor verbundenen Meßschaltungsanordnung, bei dem zumindest Teile der Meßschaltungsanordnung auf einem Schaltungsträger angeordnet sind, der mit dem Meßsensor über Verbindungsmittel positionsfest elektrisch und mechanisch verbunden ist.

Ein Batteriestromsensor, der mechanisch unmittelbar an einer Polklemme der Batterie angeordnet ist, ist aus der DE 199 61 311 A1 bekannt. Bei dem hierin beschriebenen Batteriestromsensor ist der Meßsensor als Meßwiderstand ausgebildet und über Lötverbindungen mit einer Leiterplatte verbunden. Hierbei sind die Kontaktflächen des Meßsensors aus Kupfer gefertigt, während der eigentliche Meßwiderstand aus Manganin besteht; der so gebildete Meßsensor soll dadurch den gleichen Temperaturausdehnungskoeffizienten wie das verwendete Platinenmaterial aufweisen.

Ein Batteriestromsensor gemäß des Oberbegriffs ist aus der DE 203 18 266 U1 bekannt. Hierbei ist eine Messelektronikeinheit durch federnde Kontaktelemente mit einem Meßwiderstand über eine Lötverbindung elektrisch leitend verbunden.

Aus der DE-OS 100 47 153 A1 ist eine Befestigungsvorrichtung zur Befestigung und/oder Kontaktierung einer elektrischen Einheit bekannt, die eine oberflächenmontierbare Befestigungseinheit aufweist. Die Befestigungseinheit kann Halteelemente aufweisen, die als im wesentlichen elastisch deformierbare Einheiten und speziell als Federelemente ausgebildet sein können.

Das der Erfindung zugrundeliegende Problem besteht darin, daß ein Strommeßwiderstand in einem Kraftfahrzeug während des Betriebs sehr starken Temperaturschwankungen unterliegt. Man betrachte beispielsweise ein Kraftfahrzeug, welches längere Zeit bei einer sehr niedrigen Außentemperatur abgestellt wurde, so daß dessen Batteriestromsensor bereits bis auf die Außentemperatur abgekühlt ist. Wird dieses Fahrzeug nun gestartet, so fließen während des Startvorgangs mehrere hundert Ampere über den Batteriestromsensor, wodurch sich besonders der Meßwiderstand stark erwärmt. Der dabei auftretende Temperatursprung kann leicht mehr als 100 °C betragen.

Mit diesem Temperatursprung verbunden ist eine nicht vernachlässigbare thermische Ausdehnung des Meßwiderstands. Ist der die Auswerteschaltung tragende Schaltungsträger fest, das heißt nicht über flexible Leitungen, mit dem Meßwiderstand verbunden, was aus Gründen einer kostengünstigen und fertigungstechnisch einfachen Ausgestaltung eines Batteriestromsensors bevorzugt wird, so ergibt sich das Problem, die wechselnde Temperaturausdehnung des Meßwiderstands und des Schaltungsträgers möglichst gut anzugleichen. Eine bekannte Lösung besteht, wie oben erwähnt, darin, für den Meßwiderstand und den Schaltungsträger möglichst Materialien mit ähnlichen Temperaturausdehnungskoeffizienten vorzusehen.

Nachteilig hierbei ist, daß man hierdurch bei der Auswahl der zu verwendenden Materialien stark eingeschränkt ist und resultierend daraus zumeist einen erhöhten Kostenaufwand bei der Fertigung hat. Besonders nachteilig ist, daß durch diese bekannte Maßnahme das beschriebene Problem nur unvollständig gelöst wird, da der Temperaturausgleich zwischen dem Meßwiderstand und dem Schaltungsträger eine gewisse Zeit erfordert, so daß sich thermisch bedingte mechanische Spannungen nie ganz vermeiden lassen. Des weiteren ist es, zum Schutz empfindlicher elektronischer Bauteil, auch gar nicht wünschenswert, daß der Schaltungsträger die mitunter recht hohen Temperaturen des Meßwiderstands annimmt.

Es ergab sich daher die Aufgabe, einen Batteriestromsensor zu schaffen, der eine direkte mechanische und elektrische Verbindung zwischen dem Meßsensor und dem Schaltungsträger aufweist, und bei dem die oben genannten Nachteile durch die thermische Ausdehnung des Meßsensors vermieden werden.

Diese Aufgabe wird erfindungsgemäß dadurch gelöst, daß die Verbindungsmittel jeweils mindestens einen federnden Einpreßkontakt aufweisen, über den sie mit dem Schaltungsträger und/oder mit dem Meßsensor verbunden sind.

Eine mögliche Ausgestaltung eines Einpreßkontaktes mit einem federnd ausgeführten Einpreßabschnitt ist in der US 4513499 beschrieben.

Erfindungsgemäß ermöglichen die Verbindungsmittel aufgrund ihrer federnden Eigenschaften, die sich insbesondere durch die Federwirkung der Einpreßkontakte ergeben, eine mechanisch feststehende und dennoch nicht starre mechanische und elektrische Verbindung zwischen dem Schaltungsträger und dem Meßsensor. Hierdurch werden auf einfache und kostengünstige Weise temperaturbedingte mechanische Spannungen in einem Batteriestromsensor vermieden.

Besonders vorteilhaft ist, daß durch die Einpreßkontakte eine mechanische Verbindung zwischen dem Meßsensor und dem Schaltungsträger erreichbar ist, welche eine relativ geringe thermische Kopplung aufweist. Hierdurch ist es einerseits möglich, daß sich die Temperatur des Schaltungsträgers über einen längeren Zeitraum an die mittlere Temperatur des Meßsensors angleicht, während andererseits Temperaturspitzen des Meßsensors, wie sie etwa bei einem Fahrzeugstart auftreten, keine übermäßige Erwärmung des Schaltungsträgers und darauf angeordneter temperaturempfindlicher Bauelemente bewirken können.

Des weiteren ist vorteilhaft, daß die Verwendung von Einpreßkontakten eine besonders einfache und zudem reversible Montage des Schaltungsträgers an den Meßsensor ermöglicht.

Der Meßsensor selbst kann vorteilhaft durch einen einfachen Metallstreifen ausgebildet werden. Eine mit dem Metallstreifen verbundene Meßeinrichtung wertet eine vom Stromfluß durch den Metallstreifen abhängige physikalische Größe, etwa ein aus dem Stromfluß resultierendes Magnetfeld oder eine Erwärmung aus. Eine besonders einfache und bewährte Methode der Strommessung besteht darin, einen Abschnitt des Metallstreifens als Meßwiderstand anzusehen, und die dort abfallende Spannung zu erfassen.

Im folgenden wird ein Ausführungsbeispiel der Erfindung anhand der Zeichnung dargestellt und näher erläutert werden.

### Es zeigen

- Figur 1: eine Schnittansicht eines Batteriestromsensors,
- Figur 2: eine Draufsicht auf den in der Figur 1 dargestellten Batteriestromsensor,
- Figur 3: eine vergrößerte Darstellung von Einzelheiten aus der Figur 1,
- Figur 4: eine Seitenansicht auf die in der Figur dargestellten Einzelheiten,
- Figur 5: zwei Darstellungen eines Verbindungselementes.

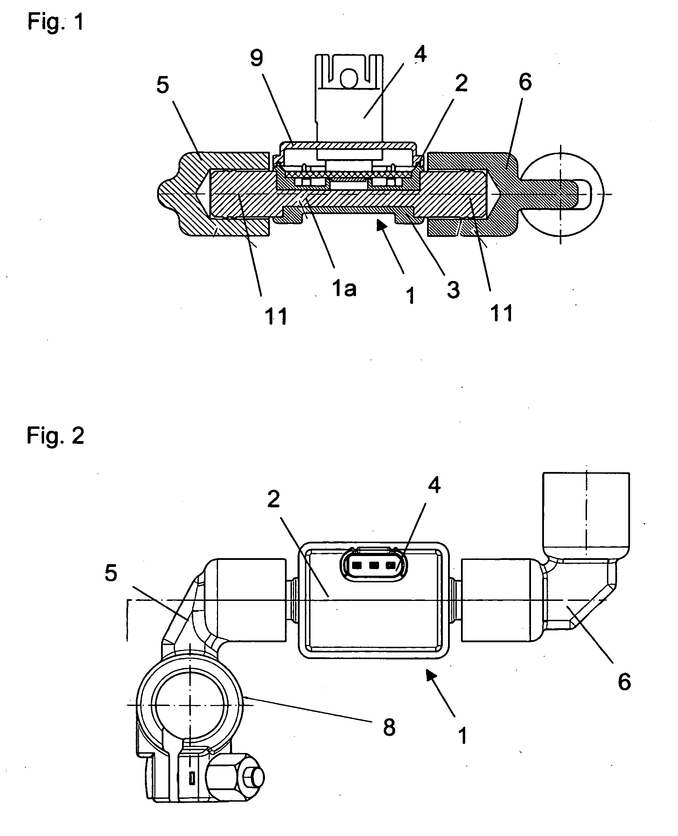

In der Figur 1 ist ein erfindungsgemäß aufgebauter Batteriestromsensor in einer Schnittansicht dargestellt. Der Batteriestromsensor besteht aus einem Meßsensor (1), mit einem durch einen Metallstreifen ausgebildeten Meßwiderstand (1 a), der in seinem mittleren Bereich eine Kunststoffumspritzung (3) aufweist, die ein Teil eines Gehäuses (2) ausbildet. Das Gehäuse (2) besitzt als ein weiteres Gehäuseteil einen Gehäusedeckel (9), der mit der Kunststoffumspritzung (3), vorzugsweise mittels einer Laserschweißung, verbunden ist, und der einen angeformten Steckerkorb als Teil eines Steckverbinders (4) aufweist.

Der Meßwiderstand (1 a) weist an seinen Endabschnitten einfache zylinderförmige Anformungen (11) auf, um deren Mittelachse Anschlußelemente (5, 6) drehbar angeordnet sind. Nach Festlegung der relativen Lage der Anschlußelemente (5, 6) relativ zum Meßsensor wird deren Positionen durch Zusammenquetschen der Verbindungsstellen arretiert.

Wie die Figur 2 verdeutlicht, ist ein erstes elektrisches Anschlußmittel (5) als Batteriepolklemme (8) ausgeführt, welche ein ringförmiges Klemmelement zum Anschluß an einen zylinder- oder konusförmigen Batteriepol aufweist.

Ein zweites elektrisches Anschlußmittel (6), das als Schraub-, Steck- oder Klemmverbinder ausgeführt sein kann, stellt die elektrische und mechanische Verbindung zu einem in der Figur nicht dargestellten Fahrzeugkabel her. Damit fließt der gesamte Batteriestrom über den Meßwiderstand (1 a), wobei die innerhalb des Kunststoffgehäuses angeordnete Meßschaltungsanordnung den Spannungsabfall an dem umspritzten Abschnitt des Meßwiderstand (1a) auswertet.

Ein dem Stromfluß durch den Meßwiderstand (1a) entsprechendes Meßsignal kann an dem Steckverbinder (4) abgenommen werden, der an den Deckel (9) des Gehäuses (2) angeformt ist.

Da die Anschlußmittel (5, 6) über die zylinderförmigen Anformungen (11) zunächst drehbar mit dem Meßsensor (1) verbunden sind, kann die Positionierung der Anschlußmittel (5, 6) relativ zum Meßsensor (1) sehr flexibel an die jeweiligen fahrzeugspezifischen Gegebenheiten angepaßt werden. Darüber hinaus können bedarfsweise auch fahrzeugspezifisch angepaßte Anschlußmittel vorgesehen werden, ohne daß bauliche Änderungen am Meßsensor (1) vorgenommen werden müßten. Hierdurch wird eine besonders einfache und kostengünstige Anpassung des Batteriestromsensors an verschiedene Fahrzeuge möglich. Nach erfolgter Positionierung der Anschlußmittel (5, 6) wird die drehbewegliche Verbindung zwischen den Anschlußmitteln (5, 6) und dem Meßsensor, beispielsweise durch Zusammenquetschen der Verbindungselemente endgültig fixiert.

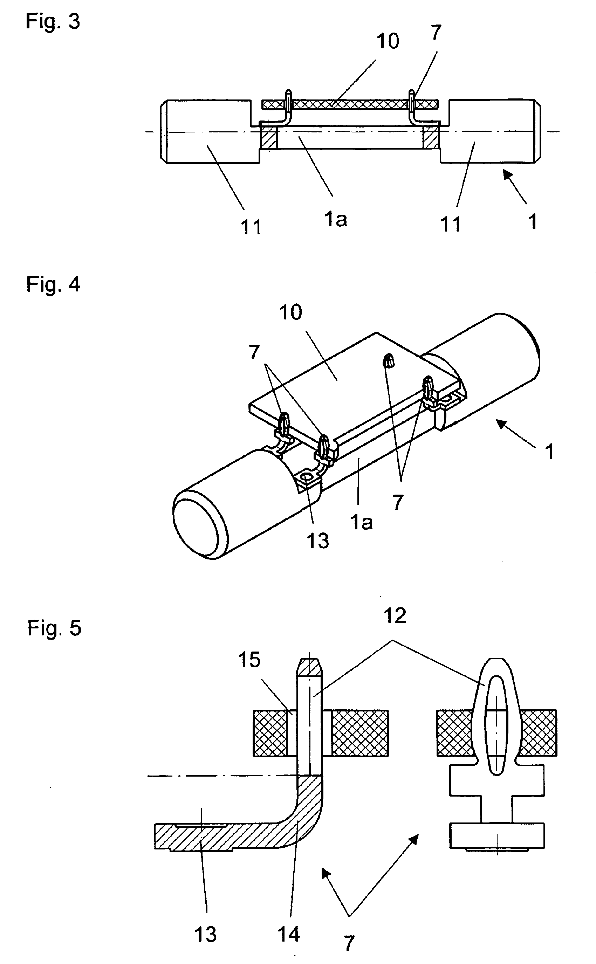

Die Figur 3 zeigt einige Einzelheiten des Batteriesensors in einer Schnittzeichnung. Zwischen seinen zylinderförmigen Anformungen (11) bildet der Meßsensors (1) einstückig einen streifenförmigen Meßwiderstand (1a) aus, an dem eine zum Batteriestrom proportionale Spannung abfällt, die von einer Meßschaltungsanordnung ausgewertet wird. Die, in der Figur nicht dargestellten Bauelemente der Meßschaltungsanordnung sind hierbei auf einem Schaltungsträger (10) angeordnet, der insbesondere eine Leiterplatte oder ein Keramiksubstrat sein kann. Die Meßschaltungsanordnung erhält das auszuwertende Meßsignal vom Meßsensor (1) über Verbindungsmittel (7) zwischen dem Meßwiderstand (1 a) und dem Schaltungsträger (10) zugeführt.

Wie besonders deutlich aus der Figur 4 hervorgeht, sind hierzu vier Verbindungsmittel (7) vorgesehen, die den Meßwiderstand (1a) und den Schaltungsträger (10) sowohl elektrisch als auch mechanisch verbinden. Die Verbindungsmittel (7) sind hier als rechtwinklig abgebogene Metallteile ausgebildet, von denen jeweils ein Verbindungsabschnitt (13) fest, beispielsweise über eine Lötverbindung oder vorzugsweise über eine Schweißverbindung, mit dem Meßwiderstand (1a) verbunden ist. Die mit dem Schaltungsträger (10) verbundenen Abschnitte der Verbindungselemente (7) sind als Einpreßkontakte (12) ausgebildet, die in Ausnehmungen (15) des Schaltungsträgers mit elektrischen leitenden Randbereichen eingesetzt sind.

Hierdurch erhält die auf dem Schaltungsträger (10) angeordnete Meßschaltungsanordnung den auszuwertenden Spannungsabfall vom Meßwiderstand (1a) zugeführt. Vorteilhaft ist, daß sich eventuell im Verbindungsbereich von den Einpreßkontakten (12) und dem Schaltungsträger (10) ergebende geringfügige Übergangswiderstände für das Meßergebnis unkritisch sind, da der Spannungsabfall am Meßwiderstand (1a) vorzugsweise durch eine hochohmige Meßschaltungsanordnung ausgewertet wird.

Die sich im Betrieb durch wechselnde Temperatur des Meßwiderstands (1a) bzw. des Meßsensors (1) verändernde thermische Ausdehnung des Meßwiderstands (1a) führt aufgrund der federnden Eigenschaften der Verbindungselemente (7) nicht zu mechanischen Spannungen in der Verbindung zum Schaltungsträger (10).

Dies verdeutlicht die Figur 5, die ein Verbindungselement (7) vergrößert in zwei Ansichten zeigt. Der in eine Ausnehmung (15) des Schaltungsträgers (10) eingesetzte Einpreßkontakt (12) besitzt die Form einer Öse und vermag aufgrund seiner federnden Eigenschaften thermische Längenänderungen des Meßwiderstand (1a, siehe Figur 4) in dessen Querrichtung auszugleichen. Ein zumindest begrenzt federnder Bereich (14) zwischen dem Einpreßkontakt (12) und dem Verbindungsabschnitt (13) des Verbindungselements (7) gleicht die thermischen Längenänderung in Längsrichtung des Meßsensors (1) aus.

Selbstverständlich sind die Ausführungsmöglichkeiten der Erfindung nicht auf dieses Ausführungsbeispiel beschränkt. So sind beispielsweise auch Ausführungen möglich, bei der die Verbindungsmittel fest mit dem Schaltungsträger und federnd mit dem Meßwiderstand verbunden sind. Ebenso ist auch eine Ausführung denkbar, bei dem beide Seiten der Verbindungsmittel mit federnden Einpreßkontakten versehen sind.

### Bezugszeichen

- 1: Meßsensor
- 1a: Meßwiderstand
- 2: Gehäuse
- 3: Kunststoffumspritzung
- 4: Steckverbinder
- 5: (erstes) Anschlußmittel
- 6: (zweites) Anschlußmittel
- 7: Verbindungsmittel
- 8: Batteriepolklemme
- 9: Gehäusedeckel
- 10: Schaltungsträger
- 11: Anformungen
- 12: Einpreßkontakt(e)
- 13: Verbindungsabschnitt(e)
- 14: federnde Bereiche
- 15: Ausnehmungen

## Patentansprüche

1. Batteriestromsensor für ein Kraftfahrzeug, mit einem in den Batteriestromkreis eingefügten Meßsensor (1) und mit einer mit dem Meßsensor (1) verbundenen Meßschaltungsanordnung, bei dem zumindest Teile der Meßschaltungsanordnung auf einem Schaltungsträger (10) angeordnet sind, der mit dem Meßsensor (1) über federnde Verbindungsmittel (7) positionsfest elektrisch und mechanisch verbunden ist, die aufgrund ihrer federnder Eigenschaften thermische Längenänderungen des Meßsensors (1) in dessen Querrichtung auszugleichen vermögen,
**dadurch gekennzeichnet,**
**daß** die Verbindungsmittel (7) jeweils mindestens einen federnden Einpreßkontakt (12) aufweisen, über den sie mit dem Schaltungsträger (10) und/oder mit dem Meßsensor (1) verbunden sind.

2. Batteriestromsensor nach Anspruch 1, **dadurch gekennzeichnet, daß** die Verbindungsmittel (7) einen Verbindungsabschnitt (13) zur Herstellung einer festen Verbindung mit dem Meßsensor (1) oder mit dem Schaltungsträger (10) aufweist.

3. Batteriestromsensor nach Anspruch 2, **dadurch gekennzeichnet, daß** die feste Verbindung eine Löt- oder Schweißverbindung ist.

4. Batteriestromsensor nach Anspruch 1, **dadurch gekennzeichnet, daß** der Einpreßkontakt (12) eine federnde Öse ausbildet.

5. Batteriestromsensor nach Anspruch 1, **dadurch gekennzeichnet, daß** das Verbindungsmittel (7) als abgewinkeltes Metallteil ausgebildet ist.

6. Batteriestromsensor nach Anspruch 1, **dadurch gekennzeichnet, daß** das Verbindungsmittel (7) als rechtwinklig abgewinkeltes Metallteil ausgebildet ist.

7. Batteriestromsensor nach Anspruch 2, **dadurch gekennzeichnet, daß** das Verbindungsmittel (7) zwischen dem Einpreßkontakt (12) und dem Verbindungsabschnitt (13) einen federnden Bereich (14) aufweist.

8. Batteriestromsensor nach Anspruch 1, **dadurch gekennzeichnet, daß** der Schaltungsträger (10) als Leiterplatte oder als Keramiksubstrat ausgebildet ist.

9. Batteriestromsensor nach einem oder mehrere der vorgenannten Ansprüche, **dadurch gekennzeichnet, daß** mehrere Verbindungsmittel (7) vorgesehen sind und daß die Einpreßkontakte (12) mit dem Schaltungsträger in Verbindung stehen und daß die Verbindungsabschnitte (13) fest mit dem Meßsensor (1) verbunden sind.

10. Batteriestromsensor nach Anspruch 1, **dadurch gekennzeichnet, daß** der Meßsensor (1) ein Meßwiderstand (1a) ist.

11. Batteriestromsensor nach Anspruch 10, **dadurch gekennzeichnet, daß** der Meßwiderstand (1a) durch einen Metallstreifen ausgebildet ist.

## Claims

1. Battery current sensor for a motor vehicle with a measuring sensor (1) inserted into the battery current circuit and with a measuring circuit arrangement connected to the measuring sensor (1), whereby at least parts of the measuring circuit arrangement are located on a circuit carrier (10) which is electrically and mechanically connected to the measuring sensor (1) in a fixed-position manner by way of resilient connecting means (7) which, due to their elastic properties, are capable of compensating thermal elongation of the measuring sensor (1) in the transverse direction of the same, **characterised by the fact,** that each of the connecting means (7) features at least one resilient press contact (12) by way of which they are connected to the circuit carrier (10) and/or to the measuring sensor (1).

2. Battery current sensor in accordance with Claim 1, **characterised by** the fact that the connecting means (7) feature a connecting section (13) for establishing a permanent connection to the measuring sensor (1) or to the circuit carrier (10).

3. Battery current sensor in accordance with Claim 2, **characterised by** the fact that the permanent connection is a soldered or welded connection.

4. Battery current sensor in accordance with Claim 1, **characterised by** the fact that the press contact (12) forms a resilient eyelet.

5. Battery current sensor in accordance with Claim 1, **characterised by** the fact that the connecting means (7) is designed as an angular metal component.

6. Battery current sensor in accordance with Claim 1, **characterised by** the fact that the connecting means (7) is designed as a metal component bent at right angles.

7. Battery current sensor in accordance with Claim 2, **characterised by** the fact that the connecting means (7) features a resilient zone (14) between the press contact (12) and the connecting section (13).

8. Battery current sensor in accordance with Claim 1, **characterised by** the fact that the circuit carrier (10) is designed as a printed circuit board or as a ceramic substrate.

9. Battery current sensor in accordance with one or more of the previous claims, **characterised by** the fact that several connecting means (7) are provided and that the press contacts (12) connect to the circuit carrier and that the connecting sections (13) are permanently connected to the measuring sensor (1).

10. Battery current sensor in accordance with Claim 1, **characterised by** the fact that the measuring sensor (1) is a measuring resistor (1 a).

11. Battery current sensor in accordance with Claim 10, **characterised by** the fact that the measuring resistor (1a) is formed by a metal strip.

## Revendications

1. Détecteur de courant de batterie pour un véhicule automobile, avec un capteur de mesure (1), incorporé dans le circuit électrique de la batterie, et avec un circuit de mesure, relié au capteur de mesure (1), dans lequel au moins des éléments du circuit de mesure sont disposés sur un support de circuit (10), qui, fixement positionné, est raccordé électriquement et mécaniquement au capteur de mesure (1), par l'intermédiaire de moyens de liaison élastiques (7), qui, en raison de leurs propriétés élastiques, sont capables de compenser des changements de longueur thermiques du capteur de mesure (1), dans la direction transversale de celui-ci, **caractérisé en ce que** les moyens de liaison élastiques (7) présentent, chacun, au moins un contact à implanter par pression (12) élastique, par l'intermédiaire duquel ils sont reliés au support de circuit (10) et / ou au capteur de mesure (1).

2. Détecteur de courant de batterie selon la revendication 1, **caractérisé en ce que** les moyens de liaison (7) présentent une section de liaison (13) pour la réalisation d'une liaison fixe au capteur de mesure (1) ou au support de circuit (10).

3. Détecteur de courant de batterie selon la revendication 2, **caractérisé en ce que** la liaison fixe est une liaison brasée ou soudée.

4. Détecteur de courant de batterie selon la revendication 1, **caractérisé en ce que** le contact à implanter par pression (12) forme une oreille élastique.

5. Détecteur de courant de batterie selon la revendication 1, **caractérisé en ce que** le moyen de liaison (7) est conçu en tant que pièce métallique coudée.

6. Détecteur de courant de batterie selon la revendication 1, **caractérisé en ce que** le moyen de liaison (7) est conçu en tant que pièce métallique, coudée. à angle droit.

7. Détecteur de courant de batterie selon la revendication 2, **caractérisé en ce que** le moyen de liaison (7) présente, entre le contact à implanter par pression (12) et la section de liaison (13), une zone élastique (14).

8. Détecteur de courant de batterie selon la revendication 1, **caractérisé en ce que** le support de circuit (10) est conçu en tant que plaquette de circuit imprimés ou en tant que substrat en céramique.

9. Détecteur de courant de batterie selon l'une ou plusieurs des revendications précédentes, **caractérisé en ce que** plusieurs moyens de liaison (7) sont prévus et que les contacts à implanter par pression (12) sont en liaison avec le support de circuit et que les sections de liaison (13) sont reliées fixement au capteur de mesure (1).

10. Détecteur de courant de batterie selon la revendication 1, **caractérisé en ce que** le capteur de mesure (1) est une résistance de mesure (1a).

11. Détecteur de courant de batterie selon la revendication 10, **caractérisé en ce que** la résistance de mesure (1a) est formée par une bande métallique.
